# EUROPÄISCHE PATENTANMELDUNG

(11) **EP 0 796 037 A1**
(43) Veröffentlichungstag der Anmeldung: **17.09.1997**
(21) Anmeldenummer: 97102071.4
(22) Anmeldetag: 10.02.1997
(51) Int. Cl.: H05K 3/28, B32B 3/00

(54) **Verfahren und Vorrichtung zur Beschichtung von Substraten, vorzugsweise Leiterplatten**

(30) Priorität: 12.03.1996 DE 19609590
(71) Anmelder: KONTRON ELEKTRONIK GMBH, D-85386 Eching (DE)
(72) Erfinder: Stadler, Andreas, 84072 Au/Osterwaal (DE); Hommel, Rolf, 81241 München (DE)
(74) Vertreter: Bullwein, Fritz

(57) **Zusammenfassung**

Bei einem Verfahren zum Beschichten von Substraten, vorzugsweise einer Leiterplatte, mit rauher Oberfläche wird ein zumindest in seiner Außenfläche fester Schichtkörper (8) mittels eines Schmelzklebers (9) auf dem Substrat befestigt, daß die dicke des Schmelzklebers mindestens gleich dem maximal Abmessungen der Oberflächenrauigkeit gewählt wird und daß der Schmelzkleber (9) einem Erwärmungsprozeß unterworfen wird.

## Beschreibung

Durch die zunehmende Miniaturisierung in der Elektronik gibt es in zunehmendem Maße die Anforderung, daß auch die Rückseite und/oder Vorderseite von Substraten, insbesondere Leiterplatten, als Sichtflächen bzw. Arbeitsflächen genutzt werden müssen. Dies trifft überall dort zu, wo konstruktions- oder funktionsbedingt für ein zusätzliches Gehäuse oder Beschichtungsteil kein ausreichender Platz vorhanden oder wo dies designbedingt nicht erwünscht ist.

Um die Oberfläche von Substraten jedoch als Sichtfläche oder auch Geräteoberfläche bzw. Arbeitsfläche nutzen zu können, wird ein Beschichtungsverfahren benötigt, welches erhabene Leiterbahnen, erhabene oder, vertiefte Testpads, Durchkontaktierungen, Lötstellen etc. so abdeckt, daß eine homogene und optisch einwandfreie Schichtoberfläche bei hoher Abrieb- und Kratzfestigkeit sowie optimalen Oberflächeneigenschaften wie Dekor, Glanzgrad, Struktur, Lichtechtheit etc. entsteht.

Darüber hinaus soll das Verfahren und die Vorrichtung sicherstellen, daß auch Schichtstoffe aufgebracht werden können, die im Verbund mit dem Substrat eine optimale Steifigkeit bzw. Festigkeit gewährleisten. Insbesondere soll der Beschichtungsstoff mit dem Substrat eine feste, jedoch lösbare Verbindung eingehen.

Des weiteren wird ein Verfahren und eine Vorrichtung benötigt, das bei geringem Produktionsmitteleinsatz und minimalen Handlingszeiten einen preisgünstigen Weg darstellt, Substrate zu beschichten.

In diesem Zusammenhang sind verschiedene Verfahren und Vorrichtungen bekannt, nämlich
a) Auftragen von Lacken, wie z.B. Lötstopplack, Füllack, Oberflächenlack, Pulverlack und dgl.
b) Aufbringen von Beschichtungsstoffen mittels Klebefilmen oder Flüssigklebstoffen oder
c) Aufbringen von selbstklebenden Beschichtungsstoffen wie z.B. Folien.

### Zu a)

Der Schichtdickenauftrag ist hierbei begrenzt. Erhabene Leiterbahnen und z.B. Lötpads etc. lassen sich nur durch Vorbereiten der Lackierung und Spachteln einebnen. Darüber hinaus ist dieses Verfahren sehr zeitaufwendig und damit teuer. Strukturen und verschiedene Dekore lassen sich hier nur mit sehr hohem Kostenaufwand realisieren.

Bei diesem Verfahren zeichnen sich außerdem meist die Leiterbahnen, Testpads, Durchkontaktierungen etc. auf der Schichtstoffoberfläche ab, die Entfernung der Beschichtung zur Reparatur oder Demontage des Substrates ist nicht möglich. Bei der Kantenbearbeitung blättert der aufgetragene Lack meist an den Kanten ab oder reißt ein.

Darüber hinaus trägt dieses Beschichtungsverfahren keinen Beitrag zur Versteifung oder Verfestigung des Substrates bei. Ein weiterer Nachteil ist, daß die Substrate vor dem Beschichten meist gewaschen werden müssen, da evtl. Flußmittelreste auf dem Substrat als Trennmittel wirken können.

Bei einseitiger Beschichtung nach diesem Verfahren tritt meist eine Krümmung des beschichteten Substrates auf.

### Zu b)

Die Handhabung von zwei Teilen, nämlich Klebefilm bzw. Flüssigkleber und Oberflächenfolie, ist aufwendig und teuer. Die Klebefilme sind hier meist auf Reaktionsharzbasis härtend ausgelegt, so daß eine Temperaturhärtung stattfindet. Dies birgt den Nachteil in sich, daß die Oberflächenbeschichtung nicht reversibel oder reparabel ist. Bei der Verwendung von nicht aushärtenden Klebefilmen entsteht der Nachteil, daß die Oberflächenbeschichtung inklusive Substrat nicht die gewünschte Steifigkeit erhält. Darüber hinaus ist eine anschließende Kantenbearbeitung nur mit hohem Aufwand möglich, da der nicht ausgehärtete Kleber immer noch wirksam ist und die Verarbeitungswerkzeuge verschmutzt. Ein weiterer Nachteil entsteht anschließend im Gebrauch des Produkts. An den nicht ausgehärteten Klebestellen sammelt sich Staub etc..

Weitere Nachteile dieses Verfahrens sind, daß bei der Verwendung von Thermoplastfolien die mechanischen Eigenschaften wie Kratzfestigkeit etc. nicht ausreichend, bei der Verwendung von dauerelastischen Klebefilmen die Haftfestigkeit der Beschichtung auf dem Substrat nicht ausreichend sowie der Korrosionsschutz von Leiterbahnen, Testpads, Lötstellen etc. nicht ausreichend gewährleistet ist.

### Zu c)

Diese Beschichtungsverfahren hat den Nachteil, daß die meist erhabenen Leiterbahnen, Lötpads etc. nicht komplett abgedeckt werden. Darüber hinaus sind die Kleber der Selbstklebefolie meist dauerelastisch, so daß eine Versteifung des gesamten Produkts nicht ausreichend ist. Nachteile bei der Kantenbearbeitung ergeben sich wie unter Punkt b.

Darüber hinaus sind die selbstklebenden Schichtstoffe meist nur dünner, z.B. Folienform, lieferbar, so daß die Forderung einer Versteifung des Substratenschichtstoffsandwiches nicht ausreichend erfüllt werden kann. Auch der Korrosionsschutz der Leiterbahnen, Lötstellen etc. kann hier nicht befriedigend gelöst werden.

Es ist Aufgabe der Erfindung, zur Beschichtung von Substraten ein kostengünstiges Verfahren und eine kostengünstige Vorrichtung zu schaffen, welche Leiterbahnen, Lötpads, Durchkontaktierungen und Lötstellen so abdeckt, daß diese an der Oberfläche nicht mehr sichtbar sind, daß eine kratzfeste und optisch einwandfreie Oberfläche der Beschichtung gewährleistet wird und daß eine feste Verbindung zwischen Beschichtungsstoff und Substrat hergestellt wird.

Außerdem sollen das Verfahren und die Vorrichtung die Steifigkeit bzw. Festigkeit der Substrate erhöhen. Weiterhin soll dieses Verfahren so ausgelegt sein, daß eine Krümmung des Substrates nach der Bestückung sowohl 1-seitig als auch 2-seitig nicht stattfindet. Des weiteren muß eine Beschichtung des Substrates mit zwei oder drei Lagen Schichtstoff möglich sein. Das Verfahren und die Vorrichtung soll auch die Aussparung insbesondere von Bauteilen auf der Platinenoberfläche ermöglichen sowie eine anschließende Kantenbearbeitung mit konventionellen Werkzeugen gewährleisten.

Weitere Anforderungen an das Verfahren und die Vorrichtung sind, daß konventionelle Schichtstoffe und Klebstoffe für eine Beschichtung von Substraten verwendet werden können. Außerdem muß das Verfahren und die Vorrichtung eine Beschichtung von ungereinigten (no-clean) Substraten ermöglichen und eine optisch einwandfreie Oberfläche gewährleisten.

Anforderungen an das Verfahren und die Vorrichtung sind: Kostengünstige einfache Vorrichtung, welche kurze Prozeß- bzw. Taktzeiten bei minimalen Handlingszeiten gewährleistet.

Diese Aufgabe wird gelöst für das Verfahren durch die Merkmale des Patentanspruchs 1, für die zugehörige Vorrichtung durch die Merkmale des Patentanspruchs 8. Die anderen Patentansprüche beinhalten vorteilhafte Weiterbildungen des Verfahrens und der Vorrichtung.

Zur Beschichtung von Substraten wird ein konventioneller Schichtstoff verwendet, wie er als Massenware in der Möbel- und Küchenindustrie Verwendung findet. Dieser Schichtstoff wird im Gegensatz zur Möbel- und Küchenindustrie mit einem thermoplastischen Schmelzkleber beschichtet. Das so entstandene Halbfertigerzeugnis wird in den zu verarbeitenden Teilen bearbeitet, insbesondere gestanzt oder gesägt. Diese Teile werden dann jeweils mit der Schmelzkleberseite zum Substrat hin in einer Art Sandwich zusammengelegt. Dieses Sandwich wird dann unter einer temperaturgesteuerten Vorrichtung erhitzt und nach einem bestimmten Zeit-Temperaturintervall von der Heizzone in eine Kaltzone überführt. Dort verweilt das Sandwich, bis der thermoplastische Schmelzkleber seine Erstarrungstemperatur erreicht hat. Daraufhin wird das so beschichtete Substrat aus der Kaltzone entnommen. Gegebenenfalls notwendige Kantenbearbeitung kann in kaltem Zustand problemlos mit konventionellen Bearbeitungswerkzeugen stattfinden. Hervorstehende Bauteile werden in beizulegenden Wärmeleitblechen ausgespart. Krümmungen bei unsymmetrischer Beschichtung werden insbesondere durch Wärmeleitbleche vermieden. Die Beschichtung ist reversibel und läßt jegliche Farbe, Struktur und Dekor in der Oberfläche zu.

Durch dieses Verfahren und die Vorrichtung lassen sich nahezu alle Substrate, bei denen insbesondere die Rückseite z.B. als Gehäuse-Außenseite oder als Sichtfläche benötigt wird, schnell und kostengünstig beschichten. Dieses Beschichtungsverfahren bietet insbesondere bei der Beschichtung von Digitizer-Tabletts beste Anwendungsmöglichkeiten.

Zur Reparatur der Substrate kann die Beschichtung durch erneutes Einbringen in die Heizzone wieder entfernt werden.

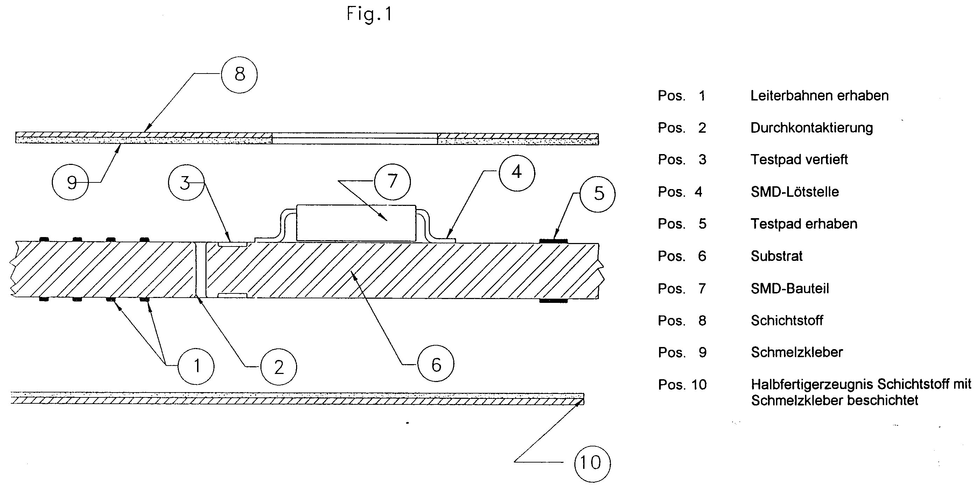

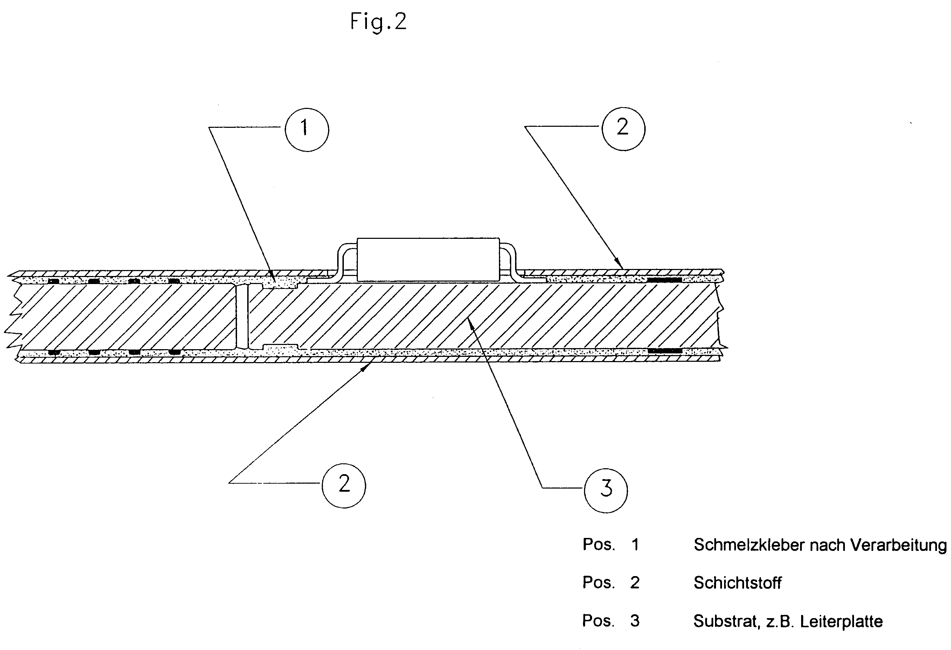

Anhand der aus Figuren 1 bis 3 mit zugehöriger Bezeichnungsliste bestehende Zeichnung ist die Erfindung weiter erläutert.

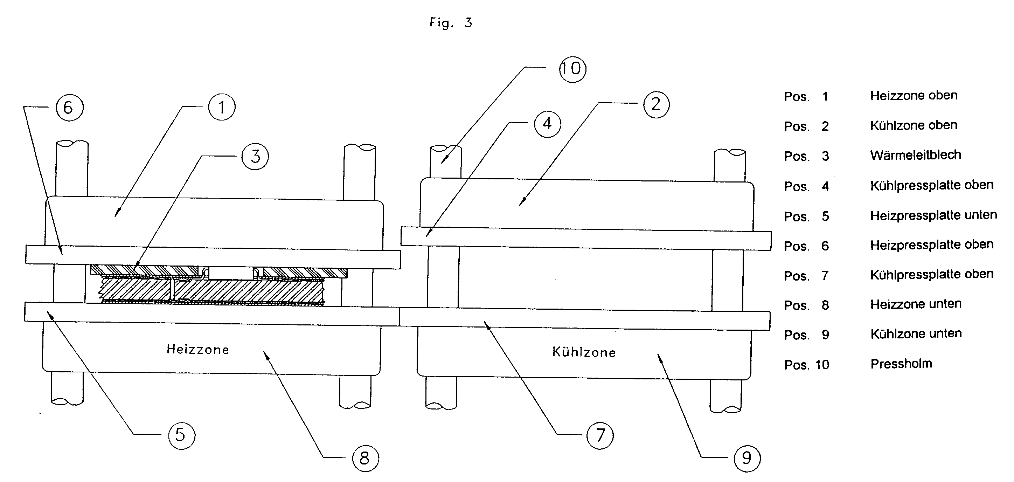

Das erfindungsgemäße Verfahren und die Vorrichtung (Fig. 3) zur Beschichtung von Substraten sind so ausgelegt, daß der Schichtstoff (Fig. 8, Fig. 1) in Dicke, Farbe, Dekor und Material beliebig gewählt werden kann. Insbesondere wird ein Duroplast-Schichtstoff verwendet, der aus mehreren Papierlagen, ggf. mit Metall-Lagen, die mit Duroplast - meist Reaktionsharz- getränkt sind, besteht. Auf diesen Schichtstoff wird Schmelzkleber (9), vorzugsweise im Sprühverfahren, aufgebracht. Die Dicke des Schmelzkleberauftrags ist ein Parameter, der das gewünschte Beschichtungsergebnis beeinflußt.

Darüber hinaus ist die zu wählende Sichtstoffdicke ebenfalls ein Parameter, der die anschließende Steifigkeit und Oberflächenqualität des fertig beschichteten Produkts beeinflußt.

Das Verfahren und die Vorrichtung ist so ausgelegt, daß das Halbfertigerzeugnis Schichtstoff mit Schmelzkleber (10) konventionell bearbeitet werden kann, vorzugsweise im Stanz- oder Sägeverfahren. Danach wird der Schichtstoff auf die Ober- bzw. Unterseite des Substrates gelegt, wobei jeweils die kleberbeschichtete Seite dem Substrat zugewendet wird. Hervorstehende Bauteile werden im Wärmeleitblech (3, Fig. 3), das dann dem Schichtstoff folgt, ausgespart.

Darüber hinaus können Krümmungen bei unsymmetrischer Beschichtung durch das Hinzulegen eines Wärmeleitbleches (3) ausgeglichen werden, wobei die Dicke des Wärmeleitbleches wiederum ein Parameter für die Wirkungsweise des Verfahrens bzw. der Vorrichtung darstellt.

Das so vorbereitete Sandwich wird nun in die Heizzone der Vorrichtung (Fig. 3) gelegt. Die obere und untere Heizzone 1 und 8 sowie die Heizpressplatten 6 und 5 sind so temperiert, daß der Schmelzkleber aufschmilzt und durch seine spezifische Viskosität, welche temperaturabhängig ist, sämtliche erhabenen und vertieften Stellen auf dem Substrat ausgleicht.

Entscheidend für das Gelingen der Beschichtung ist hierbei die Temperatureinstellung der Vorrichtung (Fig. 3). Nach einem bestimmten Zeitintervall wird die Heizplatte 6 nach oben bewegt, das Sandwich in die Kühlzone der Vorrichtung 7 verschoben und die obere obere Kühlplatte 4 zugefahren. In beiden Stellungen, also Heizen sowie Kühlen, ist der auf das Bauteil wirkende Pressdruck ein Prozeßparameter. Nach einem bestimmten Zeitintervall wird das nun erstarrte Produkt aus der Vorrichtung (Fig. 3) Kühlzone entnommen. Anschließend können Kanten, Aussparungen etc. mit konventionellen Werkzeugen bearbeitet werden. Zur Reparatur bzw. Endschichten des Substrates wird das Produkt wieder während eines bestimmten Zeitintervalls in die Heizzone eingelegt, jedoch nicht gekühlt, so daß die Beschichtung entfernt werden kann.

## Patentansprüche

1. Verfahren zum Beschichten von Substraten, vorzugsweise einer Leiterplatte, mit rauher Oberfläche, dadurch gekennzeichnet, daß ein zumindest in seiner Außenfläche fester Schichtkörper mittels eines Schmelzklebers auf dem Substrat befestigt wird, daß die dicke des Schmelzklebers mindestens gleich dem maximal Abmessungen der Oberflächenrauigkeit gewählt wird und daß der Schmelzkleber einem Erwärmungsprozeß unterworfen wird.

2. Verfahren nach Anspruch 1, dadurch gekennzeichnet, daß auch die Unterseite des Substrats mit einer aus Schichtkörper und Schmelzkleber bestehenden Beschichtung versehen wird.

3. Verfahren nach Anspruch 1 oder 2, dadurch gekennzeichnet, daß der Schmelzkleber durch Aufheizen in einer Heizzone verflüssigt wird.

4. Verfahren nach Anspruch 3, dadurch gekennzeichnet, daß die Wärme in der Heizzone durch zwei parallele Heizplatten aufgebracht wird.

5. Verfahren nach Anspruch 4, dadurch gekennzeichnet, daß die aus Leiterplatte, Schmelzkleber und Schichtkörper bestehende Anordnung verpreßt wird.

6. Verfahren nach einem der Ansprüche 1 bis 5, dadurch gekennzeichnet, daß zum Entfernen des Schichtkörpers der Schmelzkleber erneut erwärmt wird.

7. Vorrichtung zur Verwendung in einem Verfahren nach einem der Ansprüche 1 bis 6, dadurch gekennzeichnet, daß der Schichtkörper aus mehren miteinander verklebten Lagen besteht.

8. Vorrichtung nach Anspruch 7, dadurch gekennzeichnet, daß der Kleber für die Lagen einen Reaktionsharzkleber ist.
